# EUROPÄISCHE PATENTANMELDUNG

(11) **EP 0 924 528 A1**
(43) Veröffentlichungstag der Anmeldung: **23.06.1999**
(21) Anmeldenummer: 98250435.9
(22) Anmeldetag: 10.12.1998
(51) Int. Cl.: G01R 31/327

(54) **Elektronische Einrichtung zur Fehlerdiagnose von elektrischen Systemen**

(30) Priorität: 18.12.1997 DE 19758101
(71) Anmelder: MANNESMANN Aktiengesellschaft, 40213 Düsseldorf (DE)
(72) Erfinder: Prill, Thomas Dipl.Ing., 30926 Seelze (DE)
(74) Vertreter: Presting, Hans-Joachim, Dipl.-Ing.

(57) **Zusammenfassung**

Um bei einer elektronischen Einrichtung zur Fehlerdiagnose von elektrischen Systemen, insbesondere von elektropneumatischen Bremssystemen, bei der mittels einer Auswerteeinheit der Schalt- und Fehlerzustand von mindestens einem über eine Zuleitung in das elektrische System eingebundenem elektrischen Schaltgerät feststellbar ist,
einerseits einen geringen Verkabelungsaufwand zu ermöglichen und andererseits auch den Aufwand an elektronischen Bauelementen gering zu halten, wird vorgeschlagen,
daß das Schaltgerät ein Wechselschalter ist, an dessen beiden wechselnd betätigbaren Kontakten je eine Diode mit ihrem einen Anschluß angebracht ist, die beide antiparallel zueinander geschaltet sind und deren anderer Anschluß miteinander und mit einer Leitung verbunden ist und daß eine weitere Leitung von einem Schaltkontakt des Schaltgerätes ausgeht, wobei beide Leitungen die zweipolige Zuleitung zum Eingang der Auswerteeinheit bilden, die einen Wechselsignal-Generator beinhaltet, der mit dem zu überwachenden Schaltgerät und einer elektronischen Halbwellendecodier-Schaltungsanordnung einen Signalflußkreis bildet.

## Beschreibung

Die Erfindung betrifft eine elektronische Einrichtung zur Fehlerdiagnose von elektrischen Systemen, insbesondere von elektropneumatischen Bremssystemen, die den Schalt- und Fehlerzustand von Schaltgeräten überwacht, gemäß dem Oberbegriff des Patentanspruches 1.

Schaltgeräte im Sinne der Erfindung sind Schalter mit elektrischen Kontakten, die einen Stromkreis schließen oder öffnen, wie beispielsweise elektrisch betätigte Relais, manuell betätigte Schalter, mechanisch betätigte Endschalter oder fluidbetätigte Druckschalter. Derartige Schaltgeräte kommen in elektrischen Systemen - wie einer elektropneumatischen Bremssteuerung für Schienenfahrzeuge - zum Einsatz. Hier ist es aus Sicherheitsgründen geboten, betriebswichtige bzw. sicherheitsrelevante Schaltgeräte in Form von elektrisch betriebenen Absperrhähnen oder elektrischen Druckschaltern hinsichtlich ihres störungsfreien Betriebes zu überwachen.

Dafür verwendete Prinzipe zur Fehlerdiagnose sind allgemein aus dem Lehrbuch der Automatisierungstechnik (G. Strohrmann, Automatisierungstechnik, Band 1, Oldenbourg-Verlag, 1990, Seiten 331ff) bekannt. Sie dienen der eindeutigen Unterscheidung von Nutzsignal-lnformationen und Störsignal-lnformationen von Schaltgeräten, um daraus Rückschlüsse auf eventuelle Störungen, wie Leitungsbruch oder Kurzschluß ziehen zu können.

So sind zum einen Einrichtungen zur Fehlerdiagnose nach dem Redundanzprinzip bekannt. Dabei werden die sicherheitsrelevanten und insoweit auf ihre zuverlässige Funktion hin zu überwachenden Schaltgeräte mindestens 2-fach vorgesehen. Beispielsweise werden für eine Drucküberwachung zwei Druckschalter verwendet, die über eine entsprechende Zuleitung mit einer Auswerteeinheit verbunden sind. Die Auswerteeinheit erkennt den Defekt eines Druckschalters oder seiner Zuleitung daran, daß die beiden Druckschalter dann nicht die erwartungsgemäß identischen Schaltzustände aufweisen. Wird ein solcher Fehlerzustand erkannt der beispielsweise auf einen Leitungsbruch einer Zuleitung oder einen Kurzschluß im Druckschalter beruhen könnte, so gibt die Auswerteeinheit ein entsprechendes Fehlersignal aus. Eine solche nach dem Redundanzprinzip aufgebaute elektronische Einrichtung zur Fehleranalyse an Schaltgeräten elektrischer Systeme erfordert jedoch einen mehrfachen Aufwand an Schaltgeräten inklusive deren Zuleitungen. Beispielsweise bei elektropneumatischen Bremssystemen, die meist auf die gesamte Fahrzeugfläche ausgedehnt sind, geht dies mit einem hohen Verlegungsaufwand für die mehrfachen Zuleitungen einher.

Ein anderes allgemein bekanntes Prinzip für eine Einrichtung zur Fehlerdiagnose kommt ohne mehrfache Zuleitungen aus. Dabei weist ein jedes Schaltgerät eine zugeordnete intelligente mikrocontrollergesteuerte Überwachungselektronik mit integrierter Auswerteeinheit auf. Über ein Feldbus-System werden die Schalt- und Fehlerzustände des Schaltgerätes einer übergeordneten Steuerung zur Ausgabe von Fehlersignalen übermittelt. Der effizienten Zuleitung über ein ggfs. nur zweipoliges Buskabel steht jedoch bei dieser Lösung ein hoher Aufwand an elektronischen Bauelementen gegenüber, mit denen jedes Schaltgerät auszurüsten ist.

Es ist daher die Aufgabe der vorliegenden Erfindung, eine einfache und zugleich zuverlässig wirkende Einrichtung zur Fehlerdiagnose bei Schaltgeräten von elektrischen Systemen zu schaffen, die sich einerseits durch einen geringen Verkabelungsaufwand auszeichnet und die andererseits auch den Aufwand an elektronischen Bauelementen gering hält.

Die Aufgabe wird ausgehend von einer Einrichtung gemäß dem Oberbegriff des Patentanspruches 1 in Verbindung mit dessen kennzeichnenden Merkmalen gelöst.

Die Erfindung schließt die technische Lehre ein, daß ein Schaltgerät in Form eines Wechselschalters ausgebildet ist, an dessen beiden wechselnd betätigbaren Kontakten je eine Diode mit ihrem einen Anschluß angebracht ist, die beide antiparallel zueinander geschaltet sind und deren anderer Anschluß miteinander und mit einer Leitung verbunden ist, und daß eine weitere Leitung von einem Schaltkontakt des Schaltgerätes ausgeht. Dabei bilden beide Leitungen eine zweipolige Zuleitung zum Eingang einer Auswerteeinheit, die einen Wechselsignal-Generator beinhaltet, der mit dem zu überwachenden Schaltgerät und einer elektronischen Halbwellendecodier-Schaltungsanordnung einen Signalflußkreis bildet.

Damit ist es möglich, die Kontakte des Wechselschalters einzulesen und deren Zuleitung zu überwachen. Hierfür ist lediglich eine einfache Auswerteelektronik und eine Diodenbeschaltung des zu überwachenden Schaltgerätes notwendig. Es können insoweit bei Speisung mit einem Wechselsignal nunmehr vier Schaltzustände über eine zweipolige Zuleitung übertragen werden, da jede Halbwelle des Wechselsignals in Abhängigkeit des Schalt-/Fehlerzustandes im Schaltgerät und der Zuleitung einzeln auswertbar ist.

Mittels dieser Halbwellendecodierung kann demnach die Auswerteeinheit neben den Signalen, die den Schaltzustand (betätigt oder nichtbetätigt) des Schaltgerätes charakterisieren, auch die Signale, die einen Fehlerzustand (Kurzschluß oder Unterbrechung) kennzeichnen, wie folgt ausgeben:

| Schalt-/Fehlerzustand: | Übertragene Halbwelle: | Auswertung als: |
|---|---|---|
| | | |
| Schaltgerät nicht betätigt | Positive | regulärer Zustand |
| Schaltgerät betätigt | Negative | regulärer Zustand |
| Kurzschluß | Positive und Negative | Fehler |
| Leitungsbruch | keine | Fehler |

Die erfindungsgemäße Einrichtung für die Halbwellendecodierung kommt mit einer einfachen, wenig Bauelemente aufweisenden und insoweit preiswerten Elektronik aus, die von einer antiparallelen Anordnung von Dioden geprägt ist. Herkömmliche Schaltgeräte sind lediglich mit zwei Dioden auszurüsten. Bei einem relaisartigen Schaltgerät zum Schalten von Lasten, wie beispielsweise ein Schaltschutz. sind dafür die Kontakte eines freien parallelen Wechselschalters nutzbar. Bei einem Schaltgerät nch Art eines Sensors, wie beispielsweise ein Druckschalter, sind die als Wechselschalter ausgebildeten Signalkontakte direkt nutzbar. Das Sensorsignal wird hierbei herausgefiltert. Als Zuleitung ist lediglich ein zweipoliges Kabel erforderlich. Damit ist der Verkabelungsaufwand bei der erfindungsgemäßen Lösung denkbar gering. Bei Speisung der Kontakte von Schaltgeräten mit Wechselsignalen wird gegenüber einer Speisung mit reinem Gleichstrom die Kontaktlebensdauer günstig beeinflußt, da die Dauer der Schaltlichtbögen, die zu einer hohen Erwärmung der Kontaktflächen führen, auf die Zeit einer halben Periodendauer der Schaltfrequenz begrenzt ist. Ein zusätzliches kostspieliges "Fritting" der betreffenden Kontakte kann somit entfallen.

Vorzugsweise ist die Halbwellendecodier-Schaltungsanordnung aus zwei antiparallel geschalteten Polaritätsfiltern - wie Dioden - aufgebaut, denen zur Signalausgabe je ein Mittel zur Umwandlung der pulsierenden Gleichspannung in eine kontinuierliche Gleichspannung nachgeschaltet ist. Dabei kann als Mittel zur Umwandlung der pulsierenden Gleichspannung in eine kontinuierliche Gleichspannung ein Tiefpaßfilter mit nachgeschaltetem Schmitt-Trigger vorgesehen werden.

Somit ist die Haltwellendecodier-Schaltungsanordnung einfach aufgebaut und stellt an ihren zwei Ausgängen jeweils ein binäres Signal zur Verfügung. Wird dieses Ausgangssignal beispielsweise mittels einer einfachen Glühlampe zur Anzeige gebracht, so würde folglich das Aufleuchten je einer Glühlampe eine Betätigung bzw. Nicht-Betätigung als reguläre Zustände des Schaltgerätes anzeigen. Ein Aufleuchten beider Glühlampen würde auf einen Leitungskurzschluß und ein Aufleuchten keiner Glühlampe auf eine Leitungsunterbrechung hinweisen. Zusätzlich bewirkt der Einsatz des Schmitt-Triggers eine Überführung der restwelligen Gleichspannung in einen definierten Schaltzustand, so daß das ausgangsseitige Signal auch von einer nachfolgenden digitalen Steuerung weiterverarbeitet werden kann.

Vorteilhafter Weise sind die beiden Polaritätsfilter je von der Eingangsleuchtdiode eines Optokopplers gebildet, über dessen ausgangsseitigen Schalttransistor die pulsierende Gleichspannung erzeugbar ist. Somit wird eine galvanische Trennung des Signalflusses erreicht, welche die Auswerteeinheit vor Zerstörung, beispielsweise infolge einer hohen Störspannung bewahrt.

Vorzugsweise kann der Tiefpaßfilter als RC-Glied ausgebildet sein, welches dem Schalttransistor des Optokopplers nachgeschaltet ist. Somit kommen für die Tiefpaßfilterung preiswerte Bauelemente zum Einsatz, die eine kostengünstige Herstellung der Auswerteeinheit gewährleisten.

Die Anbindung der Auswerteeinheit an eine übergeordnete Steuereinheit kann zum einen über ein Bussystem erfolgen. Eine dafür vorgesehene Schnittstelle besteht aus einer Schnittstellenlogik, die mit den beiden Schmitt-Triggern je nachgeschalteten Latch-gliedern verschaltet ist.

Zum anderen kann zur Bereitstellung des von der Auswerteeinheit erzeugten Ausgangssignals der Halbwellendecodier-Schaltungsanordnung eine Flip-Flop-Einheit nachgeschaltet sein.

Eine vorteilhafte preisgünstige Ausführung des Wechselsignal-Generators ergibt sich durch Verwendung einer Kippschaltung mit Gegentaktstufe, die ein Nullsymmetrisches und im Bereich der Niederfrequenz liegendes Wechselsignal generiert.

Vorteilhafter Weise kann zur Feststellung des Schalt- und Fehlerzustandes mehrerer Schaltgeräte die Halbwellendecodier-Schaltungsanordnung mindestens eine der Anzahl der Schaltgeräte entsprechende Anzahl von Kanälen aufweisen.

Bei Verwendung langer Zuleitungen zwischen Schaltgerät und Auswerteeinheit kann es in einer störenden Umgebung zu ungünstigen elektromagnetischen Einflüssen auf die Zuleitung kommen, die sich in Störspannungen - beispielsweise schnelle Transienten - äußem würden. Zur Eliminierung dieser Störspannungen, d. h. zur Gewährleistung einer ausreichenden Störfestigkeit im Sinne der elektromagnetischen Verträglichkeit (EMV), weist die Halbwellendecodier-Schaltungsanordnung eine Transientenschutzschaltung in Form eines Eingangsfilters auf.

Weitere, die Erfindung verbessernde Maßnahmen werden nachfolgend gemeinsam mit der Beschreibung einer bevorzugten Ausführungsform der Erfindung anhand der Figuren näher dargestellt. Es zeigt:
- Fig. 1: eine Prinzipschaltung einer elektronischen Einrichtung zur Fehlerdiagnose eines Schaltgerätes,
- Fig. 2: eine Schaltungsanordnung für eine Halbwellendecodierchaltungsanordnung,
- Fig. 3: ein Blockschaltbild einer Applikationsschaltung für eine Auswerteeinheit,
- Fig. 4: ein Meßdiagramm, welches das Einschaltverhalten der Auwerteeinheit darstellt und
- Fig. 5: ein Meßdiagramm, welches das Ausschaltverhalten der Auswerteeinheit darstellt.

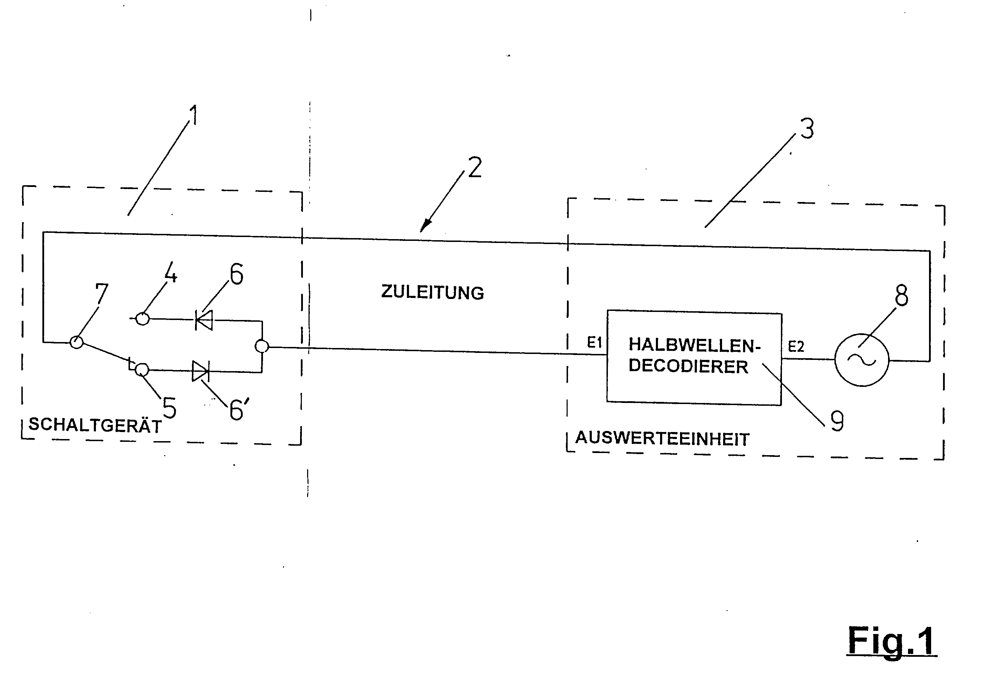

Eine elektronische Einrichtung zur Fehlerdiagnose in einem elektrischen System nach Figur 1 besteht im wesentlichen aus einem Schaltgerät 1, das über eine lange zweipolige Zuleitung 2 mit einer Auswerteeinheit 3 in Verbindung steht.

Das Schaltgerät 1 nach Art eines Wechselschalters kann beispielsweise den Schaltausgang eines Druckschalters darstellen, der bei Erreichen eines definierten Druckes in einem Druckbehälter seinen Schaltzustand ändert. An den dabei wechselnd betätigten Kontakten 4 und 5 des Schaltgerätes 1 ist je eine Diode 6 und 6' mit ihrem einen Anschluß angebracht. die Dioden 6 und 6' sind antiparallel zueinander geschaltet und mit ihrem anderen Anschluß miteinander und mit einer Leitung der zweipoligen Zuleitung 2 verbunden. Die andere Leitung der zweipoligen Zuleitung 2 geht von einem Schaltkontakt 2 des Schaltgerätes 1 aus. Die Zuleitung 2 ist an die Auswerteeinheit 3 geführt. Die Auswerteeinheit 3 beinhaltet einen Wechselsignal-Generator 8 sowie eine Halbwellendecodier-Schaltungsanordnung 9.

Das Schaltgerät 1, der Wechselsignal-Generator 8 sowie die Halbwellendecodier-Schaltungsanordnung 9 bilden einen Signalflußkreis, in dem das vom Wechselsignal-Generator 8 generierte nullsymmetrische Niederfrequenz-Wechselsignal von ca. 660 Hz mittels der im Schaltgerät 1 antiparallel angeordneten Dioden 6 und 6' je nach Schaltzustand eine Halbwellen-Filterung erfährt. Aus der so gefilterten und über die Zuleitung 2 an die Auswerteeinheit 3 rückübertragenen positiven und negativen Halbwelle erkennt die Halbwellendecodier-Schaltungsanordnung 9 den Schaltzustand - betätigt oder nicht betätigt - des Schaltgerätes 1 und stellt diesen für eine Weiterverarbeitung zur Verfügung. Die Halbwellendecodier-Schaltungsanordnung 9 analysiert darüber hinaus auch einen Fehlerzustand des Schaltgerätes 1. Erkennt die Halbwellendecodier-Schaltungsanordnung 9 keine Halbwelle, d. h. kein Eingangssignal, so liegt offensichtlich eine Unterbrechung vor, beispielsweise aufgrund eines Leitungsbruches in der langen Zuleitung 2. Empfängt dagegen die Halbwellendecodier-Schaltungsanordnung 9 beide Halbwellen des Niederfrequenz-Wechselsignals, so läßt sich auf einen Leitungskurzschluß schließen. Die Halbwellendecodier-Schaltungsanordnung 9 stellt auch diese Fehlerzustandsinformation für eine Weiterverarbeitung, beispielsweise eine Anzeige in einer zentralen Diagnoseeinheit des elektrischen Systems zur Verfügung.

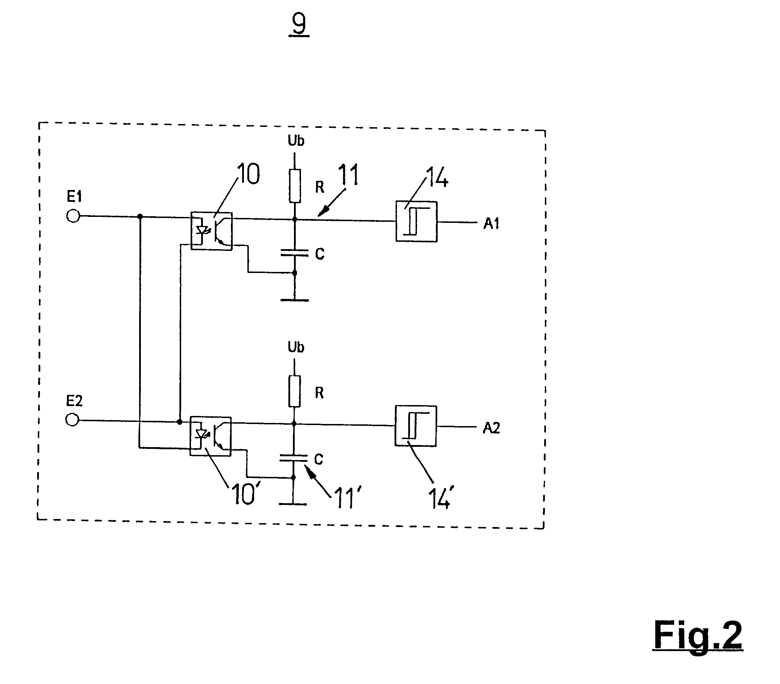

Die Halbwellendecodier-Schaltungsanordnung 9 besteht gemäß dem Schaltplan nach Figur 2 im wesentlichen aus zwei ebenfalls antiparallel zueinander geschalteten und mit den Eingängen E1 und E2 verbundenen Sendedioden von Optokopplem 10, 10', die als Polaritätsfilter dienen und außerdem die galvanische Trennung zu den Eingängen E1 und E2 gewährleisten. Den Schalttransistoren der Optokoppler 10 und 10' ist je ein RC-Glied 11, 11' als Tiefpaßfilter nachgeschaltet. Das RC-Glied 11, 11' wandelt die mittels Optokoppler 10,10' gefilterte pulsierende Gleichspannung in eine weitestgehend kontinuierliche Gleichspannung um. Durch die Schaltvorgänge der Schalttransistoren der Optokoppler 10,10' stellt sich am Kondensator C im eingeschwungenen Zustand eine Mittelspannung ein, die dem Mittelwert der treibenden Halbwelle der Sendediode des jeweiligen Optokopplers 10, 10' umgekehrt proportional ist. Der Rest-Ripple der sich einstellenden Mittelspannung wird durch die Frequenz der pulsierenden Gleichspannung und durch die Zeitkonstanten T_{E} und T_{L} bestimmt, gilt, daß T_{E} << T_{L}. Durch den Schmitt-Trigger 14, 14' wird die Mittelspannung anschließend in ein eindeutiges Schaltsignal umgewandelt und an die Ausgänge A1 sowie A2 überführt, so daß es sich digital weiterverarbeiten läßt.

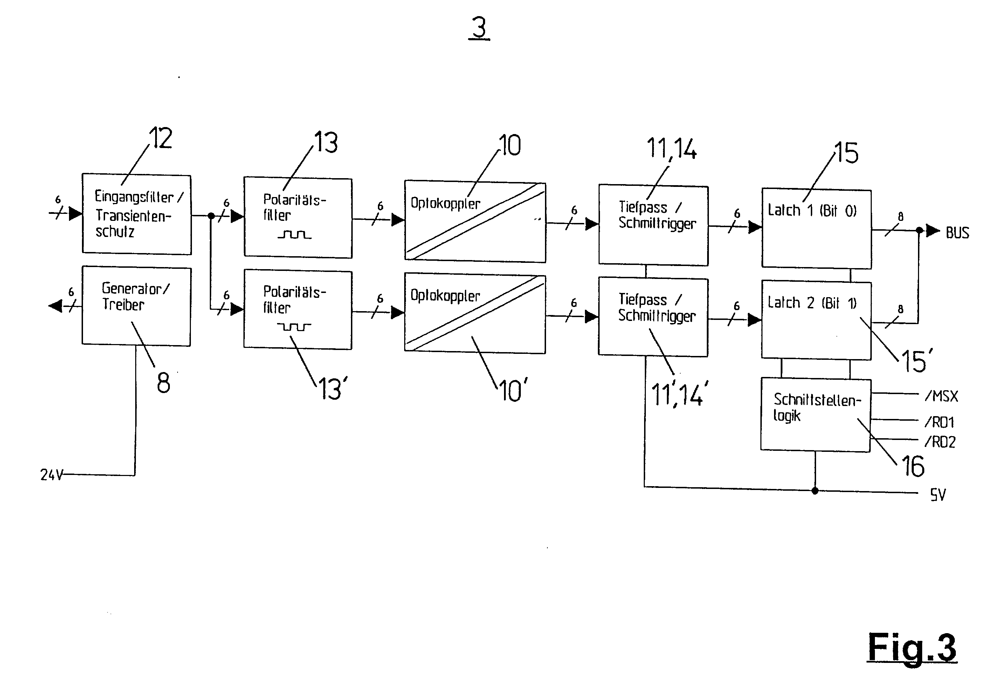

Bei einer Applikationsschaltung gemäß dem Blockschaltbild nach Figur 3 wird das der 6-kanaligen Auswerteeinheit 3 vom Schaltgerät 1 über die Zuleitung 2 zugeführte Eingangssignal zunächst auf einen Eingangsfilter 12 gegeben. Die Auswerteeinheit 3 sendet über den integrierten Wechselsignal-Generator 8 ihr nullsymmetrisches Niederfrequenz-Wechselsignal von ca. 660 Hz über die Zuleitung 2 zum Schaltgerät 1. Der Eingangsfilter 12 beinhaltet eine Transientenschutzschaltung, die eine ausreichende Störfestigkeit im Sinne der elektromagnetischen Verträglichkeit (EMV) sicherstellt. Dem Eingangsfilter 12 sind die als Polaritätsfilter 13, 13' dienenden antiparallel geschalteten Sendedioden der Optokoppler 10, 10' nachgeschaltet. Diese liefern ein im stationären Zustand antivatentes Signal. Nach den der galvanischen Trennung dienenden Optikopplem 10, 10' passiert das jeweilige Halbwellensignal zur Glättung einen Tiefpaßfilter in Form des RC-Gliedes 11,11' mit nachgeschaltetem Schmitt-Trigger 14, 14'. Das so vorliegende digital weiterverarbeitbare Signal wird an entsprechende Latch-Glieder 15, 15' weitergeleitet, die in Verbindung mit einer Schnittstellenlogik 16 eine Anbindung an ein Bussystem gewährleisten. Damit ist das über das Bussystem übertragbare Auswertesignal von einer in der Figur nicht dargestellten übergeordneten Steuereinheit, beispielsweise einer Fehlerdiagnoseeinheit erfaßbar und ausgebbar.

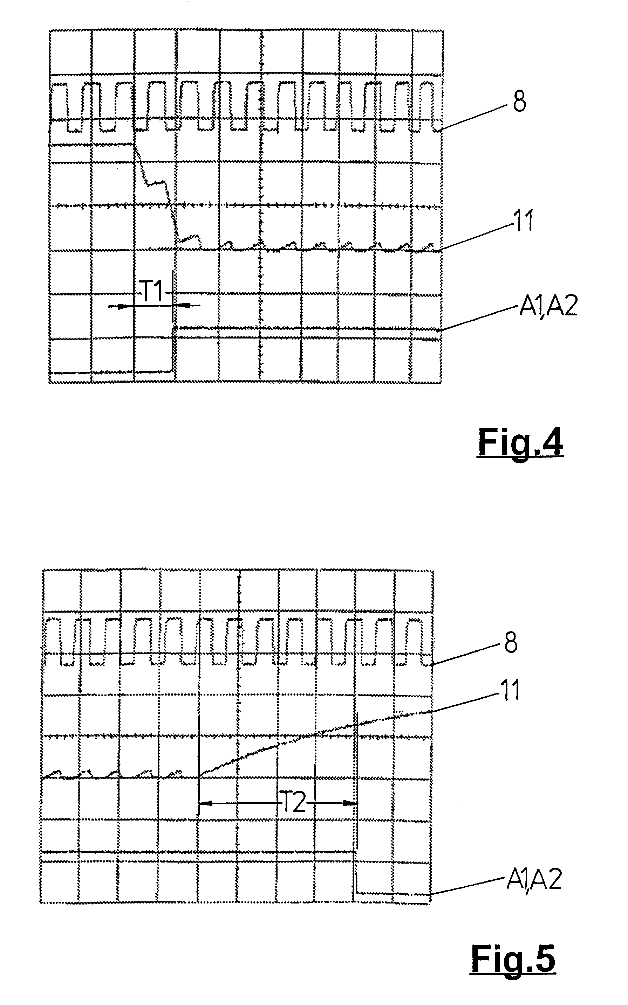

In Figur 4 ist das Einschaltverhalten einer Applikationsschaltung anhand eines Meßschriebes dargestellt. Die gemessene Zeitverzögerung beim Einschalten beträgt lediglich T₁ = 1,9 ms und wird durch die Entlade-Zeitkonstante T_{E} sowie der Ausschalt-Schwelle des Schmitt-Triggers bestimmt. Die Grenzfrequenz der Halbwellendecodier-Schaltungsanordnung 9 in der Applikationsschaltung wird im wesentlichen durch die Zeitkonstante des RC-Gliedes 11 von T = R ∗ C ≈ 10 ms und der Frequenz des Wechselsignal-Generators 8 von ca. 660 Hz bestimmt und führt in Verbindung mit der Schalthysterese des Schmitt-Trigger 14 zu einer errechneten maximalen System-Totzeit von Tsysₜₒₜ ≤ 8 ms.

Die Figur 5 zeigt das Ausschaltverhalten des Schmitt-Trigger 14 gemessen am Ausgang A1 bzw. A2 des Schmitt-Triggers 14, bei der Applikationsschaltung anhand eines weiteren Meßschriebes. Die gemessene Totzeit ergibt im Gegensatz zum Einschalten beim Ausschalten hier einen längeren Zeitwert von T₂ = 8,2 ms, bestimmt durch die Lade-Zeitkonstante T_{L} sowie der Einschalt-Schwelle des Schmitt-Triggers 14. Unter Zugrundelegung der Umladedauer des RC-Gliedes 11, der dafür benötigten Impulse des Wechselsignal-Generators 8 und der Totzeiten Tsysₜₒₜ bzw. T₂ ist die Grenzfrequenz für die Umschaltung des Schaltgerätes 1 bei der Applikationsschaltung auf maximal 100 Hz begrenzt. Um eine zuverlässige Funktion der Halbwellendecodier-Schaltungsanordnung 9 sicherzustellen, muß die Schaltfrequenz des Schaltgerätes 1 stets unterhalb ihrer Grenzfrequenz liegen.

### Bezugszeichenliste

- 1: Schaltgerät
- 2: Zuleitung, zweipolig
- 3: Auswerteeinheit
- 4: Kontakt, erster
- 5: Kontakt, zweiter
- 6: Diode
- 7: Schaltkontakt
- 8: Wechselsignal-Generator
- 9: Halbwellendecodier-Schaltungsanordnung
- 10: Optokoppler
- 11: RC-Glied
- 12: Eingangsfilter
- 13: Polaritätsfilter
- 14: Schmitt-Trigger
- 15: Latch-Glied
- 16: Schnittstellenlogik
- E1: Erster Eingang
- E2: Zweiter Eingang
- A1: Erster Ausgang
- A2: Zweiter Ausgang
- C: Kondensator
- R: Widerstand

## Patentansprüche

1. Elektronische Einrichtung zur Fehlerdiagnose von elektrischen Systemen, insbesondere von elektropneumatischen Bremssystemen, bei der mittels einer Auswerteeinheit (3) der Schalt- und Fehlerzustand von mindestens einem über eine Zuleitung (2) in das elektrische System eingebundenem elektrischen Schaltgerät (1) feststellbar ist,
dadurch gekennzeichnet,
daß das Schaltgerät (1) ein Wechselschalter ist, an dessen beiden wechselnd betätigbaren Kontakten (4, 5) je eine Diode mit ihrem einen Anschluß angebracht ist, die beide antiparallel zueinander geschaltet sind und deren anderer Anschluß miteinander und mit einer Leitung verbunden ist, und daß eine weitere Leitung von einem Schaltkontakt (7) des Schaltgerätes (1) ausgeht, wobei beide Leitungen die zweipolige Zuleitung (2) zum Eingang der Auswerteeinheit (3) bilden, die einen Wechselsignal-Generator (8) beinhaltet, der mit dem zu überwachenden Schaltgerät (1) und einer elektronischen Halbwellendecodier-Schaltungsanordnung (9) einen Signalflußkreis bildet.

2. Elektronische Einrichtung nach Anspruch 1,
dadurch gekennzeichnet,
daß die Halbwellendecodier-Schaltungsanordnung (9) aus zwei antiparallel geschalteten Polaritätsfiltern aufgebaut ist, denen zur Signalausgabe je ein Mittel zur Umwandlung der gefilterten pulsierenden Gleichspannung in eine kontinuierliche Gleichspannung nachgeschaltet ist.

3. Elektronische Einrichtung nach Anspruch 2,
dadurch gekennzeichnet,
daß als Mittel zur Umwandlung der gefilterten pulsierenden Gleichspannung in eine kontinuierliche Gleichspannung ein Tiefpaßfilter in Form eines RC-Gliedes (11, 11') mit nachgeschaltetem Schmitt-Trigger (14, 14') vorgesehen ist.

4. Elektronische Einrichtung nach Anspruch 2,
dadurch gekennzeichnet,
daß zur galvanischen Trennung die beiden Polaritätsfilter je von der Eingangsleuchtdiode eines Optokopplers (10, 10') gebildet sind, über dessen ausgangsseitigen Schalttransistor die gefilterte pulsierende Gleichspannung erzeugbar ist.

5. Elektronische Einrichtung nach Anspruch 1,
dadurch gekennzeichnet,
daß zur Anbindung der Auswerteeinheit (3) an eine übergeordnete Steuereinheit über ein Bussystem der Halbwellendecodier-Schaltungsanordnung (9) ausgangsseitig eine Schnittstelle zugeordnet ist, die aus einer Schnittstellenlogik (16) besteht, die mit den beiden Schmitt-Triggern (14, 14') je nachgeschalteten Latch-Gliedern (15, 15') verschaltet ist.

6. Elektronische Einrichtung nach Anspruch 1,
dadurch gekennzeichnet,
daß zur Bereitstellung des von der Auswerteeinheit (3) erzeugten Ausgangssignals der Halbwellendecodier-Schaltungsanordnung (9) eine Flip-Flop-Einheit nachgeschaltet ist.

7. Elektronische Einrichtung nach Anspruch 1,
dadurch gekennzeichnet,
daß der Wechselsignal-Generator (8) mittels einer Kippschaltung mit Gegentaktstufe ein nullsymmetrisches und im Bereich der Niederfrequenz liegendes Wechselsignal generiert.

8. Elektronische Einrichtung nach Anspruch 1,
dadurch gekennzeichnet,
daß zur Feststellung des Schalt- und Fehlerzustandes mehrerer Schaltgeräte (1) die Halbwellendecodier-Schaltungsanordnung (9) mindestens der Anzahl der Schaltgeräte (1) entsprechend mehrkanalig ausgeführt ist.

9. Elektronische Einrichtung nach Anspruch 1,
dadurch gekennzeichnet,
daß zur Gewährleistung einer ausreichenden Störfestigkeit im Sinne der elektromagnetischen Verträglichkeit (EMV) die Halbwellendecodier-Schaltungsanordnung (9) einen Eingangsfilter (12) mit Transientenschutzschaltung aufweist.
